# EUROPEAN PATENT APPLICATION

(11) **EP 2 161 737 A1**
(43) Date of publication of application: **10.03.2010**
(21) Application number: 08765658.3
(22) Date of filing: 16.06.2008
(51) Int. Cl.: H01L 21/304, B24B 37/00, C09K 3/14

(54) **POLISHING COMPOSITION AND METHOD FOR MANUFACTURING SEMICONDUCTOR INTEGRATED CIRCUIT DEVICE**

(30) Priority: 20.06.2007 JP 2007162768
(71) Applicant: Asahi Glass Co., Ltd., Tokyo 100-8405 (JP)
(72) Inventor: TAKEMIYA, Satoshi, Tokyo 100-8405 (JP); YOSHIDA, Iori, Tokyo 100-8405 (JP)
(74) Representative: Müller-Boré & Partner Patentanwälte
(86) International application number: PCT/JP2008/060975
(87) International publication number: WO 2008/156054

(57) **Abstract**

In polishing of a to-be-polished surface in the production of a semiconductor integrated circuit device, a flat surface of an insulating layer having an embedded metal interconnect can be obtained. Further, a semiconductor integrated circuit device having a highly planarized multilayer structure can be obtained. Provided is a polishing composition which is a chemical mechanical polishing composition for polishing a to-be-polished surface of a semiconductor integrated circuit device, contains one or more oxidizing agents selected from the group consisting of hydrogen peroxide, ammonium persulfate and potassium persulfate, an abrasive grain, an alicyclic resin acid, a basic compound and inorganic acid, and has a pH ranging from 8 to 12.

## Description

### TECHNICAL FIELD

The present invention relates to a chemical mechanical polishing composition used in a production step of a semiconductor integrated circuit device, and a production method of a semiconductor integrated circuit device. More specifically, the invention relates to a chemical mechanical polishing composition suitable for formation of an embedded metal interconnect, for example, using copper metal as a interconnect material and a tantalum-based metal as a barrier layer material, and a production method of a semiconductor integrated circuit device by using the same.

### BACKGROUND ART

With the recent progress toward higher integration and higher functionality of semiconductor integrated circuit devices, development of microfabrication techniques for realizing refinement and high density have been forwarded in production steps of semiconductor integrated circuit devices. In particular, in a multilayer interconnect forming step, a planarizing technique of an interlayer insulating layer or an embedded interconnect is important.

As an interconnect material, attention has been attracted to copper having a low specific resistance and excellent electromigration resistance. For formation of a copper interconnect, a Damascene method is used in which a trench portion such as an interconnect pattern is formed on an insulating layer, a barrier layer for preventing diffusion of copper is formed, thereafter, a copper layer is formed so as to be embedded in the trench portion by a sputtering method or a plating method, and the excess copper layer and the excess barrier layer are removed by a chemical mechanical polishing method (CMP: Chemical Mechanical Polishing; hereinafter referred to as CMP) until the surface of the insulating layer except for the trench portion is exposed to planarize the surface, thereby forming an embedded metal interconnect. As the barrier layer, there is used a tantalum type barrier layer comprising a tantalum compound such as tantalum, a tantalum alloy or tantalum nitride.

In such copper embedded interconnect formation, it is necessary to remove by CMP the barrier layer exposed by the removal of the excess copper layer, in the portions other than the embedded interconnect portion. However, tantalum or the tantalum compound used as the barrier layer is chemically stable and hard to be etched, and has a higher hardness as compared with copper. Accordingly, a sufficient polishing rate is not obtained with respect to copper in many cases. In view of this, there has been proposed a two-step polishing method comprising a first step for removing an excess metal interconnect layer and a second step for removing an excess barrier layer.

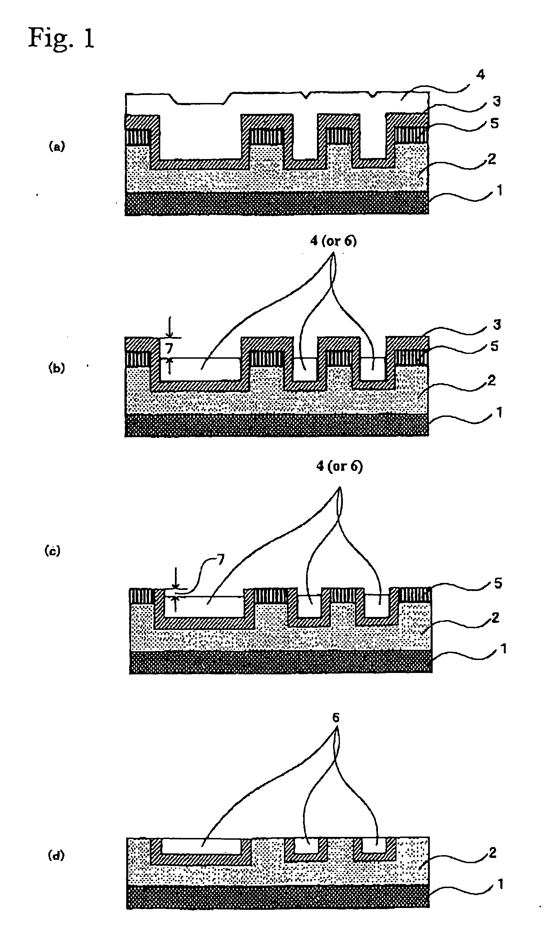

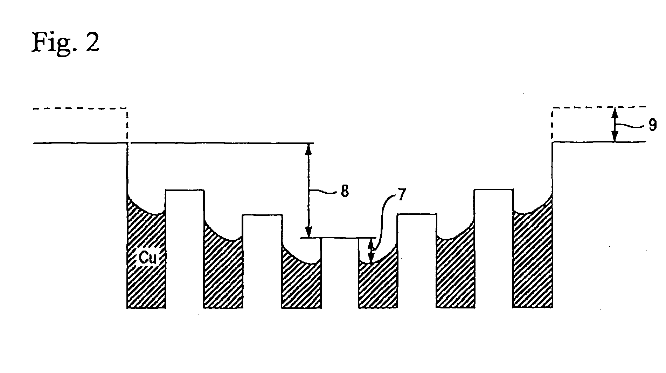

A method for forming an embedded metal interconnect by CMP will be explained with reference to Fig. 1 and Fig. 2. In these figures, a case of using a cap layer 5 comprising an insulating material such as silicon dioxide is exemplified. However, there may also be the case of using no cap layer, and the same also applies to that case.

Fig. 1(a) is a cross-sectional view showing a state before polishing in which trenches for forming embedded interconnects 6 are first formed on an insulating layer, which is formed on a substrate 1, and on the cap layer, and then, a barrier layer 3 and a metal interconnect layer 4 are formed in this order. Fig. 1 (b) is a cross-sectional view showing a state after the first polishing step for removing an excess portion of the metal interconnect layer 4 has been performed. After the termination of the first polishing step, there occurs loss of the metal interconnect layer called dishing 7 as indicated by the arrow shown in Fig. 1(b) or loss of insulating layer called erosion 8 as indicated by the arrow 8 in Fig. 2. Such dishing or erosion, or a scratch causes an increase in interconnect resistance or electromigration of a semiconductor integrated circuit device to deteriorate the reliability of the device.

The dishing 7 means a dent formed in a central part of an interconnect portion by over-polishing of the metal interconnect layer 4 or the dent amount thereof, as designated by reference numeral 7 in Fig. 1 (b) or Fig. 2. The erosion means a dent formed by that polishing proceeds faster in a portion having a narrow interconnect width or a portion having a high interconnect density of the interconnect portion, than an insulating layer portion (global part) having no interconnect pattern, a portion having a wide interconnect width or a portion having a low interconnect density, to over-polish the insulating layer 2 relative to the global part, as designated by the arrow 8 in Fig. 2, or the dent amount thereof. In Fig. 2, the barrier layer 3 is omitted.

By the second polishing step subsequently conducted, polishing is performed to remove the unnecessary barrier layer and cap layer 5, and to remove the dishing and erosion generated in the first polishing step. Fig. 1(c) is a cross-sectional view in the course of the second polishing step. The barrier layer exposed by removing the excess copper layer has been removed, but the dishing 7 remains. The cross-sectional view shown as Fig. 1(d) is a cross-sectional view after polishing at the time when the second polishing step is ideally performed, and the metal interconnect layer and the insulating layer are finished to a flat surface in which they have been made to have the same surface level. In Figs. 1, the cap layer 5 is entirely removed, but it is not necessarily entirely removed.

In the second polishing, it is necessary to perform polishing from a state where the metal interconnect layer has dishing to the flat surface where the metal interconnect layer and the insulating layer have the same surface level. Accordingly, in the polishing composition used in the second polishing step, it is necessary that the polishing rate of the metal interconnect layer is small relative to the polishing rate of the barrier layer and to the insulating layer such as silicon dioxide or a low-dielectric constant film, and that the ratio of these polishing rates is within a desired range, i.e., "selective".

However, the CMP is known to have problems to be solved in connection with planarization by polishing, such as a phenomenon called dishing in which the interconnect portion is scraped off lower than the flat surface, a phenomenon called erosion in which a plurality of interconnects closely disposed in association with high densification of metal interconnects are scraped off together with a peripheral material such as an insulating material. With respect to the dishing and the erosion, a number of means for solution have hitherto been proposed, but they have not been fully satisfactory.

It is disclosed, for example, in Patent Document 1 that a protective film forming agent comprising a triazole-based compound including benzotriazole (hereinafter referred to as BTA) is added to a polishing composition, in order to inhibit the occurrence of dishing or erosion and to obtain the above-mentioned polishing rate ratio of the barrier layer : metal interconnect layer : insulating layer in the second polishing step.

Further, Patent Document 2 discloses a polishing composition using fumed silica as an abrasive grain, and 5-amino-1H-tetrazole, guanine or 3-mercapto-1,2,4-triazole as a polishing rate adjusting agent, in which the pH is adjusted to 1 to 8 with an inorganic acid such as nitric acid, sulfuric acid or phosphoric acid, or an organic acid such as formic acid, acetic acid, oxalic acid, malonic acid, succinic acid and benzoic acid, thereby selectively polishing a barrier layer.
In Patent Document 1, BTA is used as an anti-corrosion agent. BTA is adsorbed by a Cu surface to be able to prevent corrosion. On the other hand, the degree of adsorption is strong, so that the Cu surface after polishing shows water repellency, or residual BTA has adverse effects on subsequent steps in some cases. Further, BTA adsorbed by the Cu surface is not uniform in many cases, so that there is a concern that local corrosion may be liable to occur. Compared to this, according to the invention, the degree of adsorption is moderate, so that the Cu surface after polishing shows hydrophilicity, and a residual anti-corrosion agent gives no adverse effects on the subsequent steps.
In Patent Document 2, the polishing rate of Cu is extremely slow relative to the polishing rate of tantalum. That is, it is impossible to eliminate the difference in level. Further, tetrazole exemplified as the Cu anti-corrosion agent is a nitrogen-containing compound containing many nitrogen atoms in its molecule, and a hazardous material under the Fire Defense Law. This is therefore hard to handle.

Patent Document 1: PCT International Publication No. 2003/036705
Patent Document 2: JP-A-2001-077062

### DISCLOSURE OF THE INVENTION

### PROBLEMS TO BE SOLVED BY THE INVENTION

It is an object of the invention to provide a polishing composition for realizing a flat to-be-polished surface of an insulating layer and an embedded metal interconnect embedded, by CMP, in a step for forming an embedded metal interconnect in the production of a semiconductor integrated circuit device. Other objects and advantageous effects of the invention will become apparent from the following description.

### MEANS FOR SOLVING THE PROBLEMS

Embodiment 1 of the present invention provides a polishing composition containing an oxidizing agent, an abrasive grain, an alicyclic resin acid, a basic compound and water, and having a pH ranging from 8 to 12.

When the polishing composition of this embodiment is used, a to-be-polished surface can be highly flatly polished in CMP of a production step of an embedded metal interconnect in a production step of a semiconductor integrated circuit.
Thereby, a semiconductor integrated circuit having a highly planarized multilayer structure can be obtained. Further, washing of the to-be-polished surface after CMP is easy, so that adverse effects on subsequent steps caused by that components of the polishing composition are adsorbed to remain thereon can be inhibited.

Embodiment 2 of the present invention provides a polishing composition according to embodiment 1, containing 0.05 to 10% by mass of the oxidizing agent, 0.1 to 15% by mass of the abrasive grain, 0.001 to 5% by mass of the alicyclic fatty acid, 0.1 to 20% by mass of the basic compound and 78% by mass or more of water, each based on the total amount of the polishing composition.
In this case, in addition to the effects of embodiment 1, the to-be-polished surface having a barrier layer, a copper layer, a cap layer and an insulating layer can be further highly flatly polished.

Embodiment 3 of the present invention provides a polishing composition according to embodiment 1 or 2, wherein the alicyclic resin acid is at least one member selected from the group consisting of abietic acid, isomers of abietic acid, pimaric acid, isomers of pimaric acid, rosin, and derivatives of these compounds.
In this case, in addition to the effects of embodiment 1 or 2, the to-be-polished surface can be further highly flatly polished in CMP of the production step of the embedded metal interconnect in the production step of the semiconductor integrated circuit. Thereby, a semiconductor integrated circuit having a further highly planarized multilayer structure can be obtained.

Embodiment 4 of the present invention provides a polishing composition according to embodiment 1, 2 or 3, wherein the oxidizing agent is one or more member selected from the group consisting of hydrogen peroxide, ammonium persulfate and potassium persulfate.

Embodiment 5 of the present invention provides a polishing composition according to any one of embodiments 1 to 4, wherein the basic compound is at least one member selected from the group consisting of basic potassium compounds, ammonium and organic amines. In this case, in addition to the effects of embodiments 1 to 4, the polishing rate of the barrier layer or the insulating layer can be changed to adjust the polishing rate ratio of the barrier layer or the insulating layer relative to the interconnect metal layer.

Embodiment 6 of the present invention provides a polishing composition according to any one of embodiments 1 to 5, wherein the abrasive grain is particles comprising at least one member selected from the group consisting of silica, alumina, ceria, zirconia, titanium oxide, tin oxide, zinc oxide, germanium oxide and manganese oxide.
In this case, in addition to the effects of any one of embodiments 1 to 5, the to-be-polished surface can be highly flatly polished in CMP of the production step of the embedded metal interconnect in the production step of the semiconductor integrated circuit. Thereby, a semiconductor integrated circuit having a highly planarized multilayer structure can be obtained.

Embodiment 7 of the present invention provides a polishing composition according to any one of embodiments 1 to 6, wherein the abrasive grain has an average particle size of 5 to 300 nm.

In this case, in addition to the effects of any one of embodiments 1 to 6, the to-be-polished surface can be highly flatly polished in CMP of the production step of the embedded metal interconnect in the production step of the semiconductor integrated circuit. Thereby, a semiconductor integrated circuit having a highly planarized multilayer structure can be obtained.

Embodiment 8 of the present invention provides a polishing composition according to any one of embodiment 1 to 7, further comprising an inorganic acid, wherein the content of the inorganic acid is 0.1 to 10% by mass based on the total amount of the polishing composition. In this case, in addition to the effects of any one of embodiments 1 to 7, the polishing rate of the barrier layer or the insulating layer can be changed to adjust the polishing rate ratio of the barrier layer or the insulating layer relative to the interconnect metal layer. Further, the dispersion stability of the polishing composition can be improved.

Embodiment 9 of the present invention provides a polishing composition according to any one of embodiments 1 to 8, further comprising a long-chain aliphatic carboxylic acid having at least a long-chain hydrocarbon group having 10 to 22 carbon atoms and one or more carboxy groups. When the polishing composition of this embodiment is used the polishing rate of the copper layer and the insulating layer comprising SiOC can be adjusted, and the to-be-polished surface can be flatly polished, in CMP of the production step of the embedded metal interconnect in the production step of the semiconductor integrated circuit.

Embodiment 10 of the present invention provides a polishing composition according to any one of embodiments 1 to 9, comprising at least one organic carboxylic acid selected from the group consisting of citric acid, succinic acid, tartaric acid, malic acid and oxalic acid. In this case, in addition to the effects of any one of embodiments 1 to 9, the to-be-polished surface can be further highly flatly polished by adjusting the polishing rate of the copper layer.

Embodiment 11 of the present invention provides a polishing composition according to any one of embodiments 1 to 10, which gives a polishing rate of a barrier layer, PR_{BR}, that is equal to or higher than each of its polishing rate of a copper layer, PR_{Cu}, its polishing rate of a cap layer, PR_{Cap}, and its polishing rate of an insulating layer, PR_{Ins}, and wherein the ratio of the insulating layer polishing rate PR_{Ins} and the cap layer polishing rate PR_{Cap}, PR_{Ins}/PR_{Cap}, is 0.7 or less.

In this case, in addition to the effects of any one of embodiments 1 to 10, the to-be-polished surface having the barrier layer, the copper layer, the cap layer and the insulating layer can be further highly flatly polished.

Embodiment 12 of the present invention provides a polishing composition according to any one of embodiments 1 to 11, comprising 0.1 to 5% by mass of hydrogen peroxide, 1 to 10% by mass of silica particles, 0.001 to 5% by mass of the alicyclic fatty acid, 0.1 to 10% by mass of the basic compound and 85% by mass or more of water, each based on the total amount of the polishing composition.

In this case, in addition to the effects of any one of embodiments 1 to 11, the to-be-polished surface having the barrier layer, the copper layer, the cap layer and the insulating layer can be further highly flatly polished in CMP of the production step of the embedded metal interconnect in the production step of the semiconductor integrated circuit. Further, washing of the to-be-polished surface after the CMP is easy, so that adverse effects on subsequent steps caused by that components of the polishing composition are adsorbed to remain thereon can be inhibited. Thereby, a semiconductor integrated circuit having a highly planarized multilayer structure can be stably obtained.

Embodiment 13 of the present invention provides a method for producing a semiconductor integrated circuit device, wherein the semiconductor integrated circuit device comprises an insulating layer having a trench portion, and an embedded metal interconnect formed in the trench portion, the method comprising a step of polishing a to-be-polished surface comprising a barrier layer and a metal interconnect layer formed in this order in the trench portion, by using the polishing composition according to any one of embodiments 1 to 12, to form the embedded metal interconnect

When the method for producing a semiconductor integrated circuit device of this embodiment is used, the to-be-polished surface having a barrier layer, a copper layer, a cap layer and an insulating layer can be highly flatly polished. Accordingly, a semiconductor integrated circuit having a highly planarized multilayer structure can be stably obtained.

Embodiment 14 of the present invention provides a method for producing a semiconductor integrated circuit device according to embodiment 13, wherein the metal interconnect layer comprises copper as a main component, and the barrier layer comprises one or more member selected from the group consisting of tantalum, tantalum alloys and tantalum compounds. In this case, in addition to the effect of embodiment 13, diffusion of copper into the insulating layer can be sufficiently prevented, and a semiconductor integrated circuit device which has good flatness and is capable of multilayering of a large number of layers can be produced.

Embodiment 15 of the present invention provides a method for producing a semiconductor integrated circuit device according to embodiment 13 or 14, wherein the insulating layer comprises a low-dielectric insulating layer made of a low-dielectric material and a cap layer formed thereon, and the barrier layer and the metal interconnect layer are formed on the trench portion and the cap layer. In this case, in addition to the effect(s) of embodiment 13 or 14, the flatness is further improved, so that a semiconductor integrated circuit having a well reliable multilayer structure can be stably obtained.

### ADVANTAGES OF THE INVENTION

When the polishing composition of the invention is used, a to-be-polished surface can be highly flatly polished in CMP of a production step of an embedded metal interconnect in a production step of a semiconductor integrated circuit. Thereby, a semiconductor integrated circuit having a highly planarized multilayer structure can be obtained. Further, washing of the to-be-polished surface after CMP is easy, so that adverse effects on subsequent steps caused by that components of the polishing composition are adsorbed to remain thereon can be inhibited. Furthermore, a semiconductor integrated circuit having a highly planarized multilayer structure can be obtained.

### BRIEF DESCRIPTION OF THE DRAWINGS

[Figs. 1] Figs.1 are schematic cross-sectional views of a semiconductor integrated circuit device in steps indicating a method of forming an embedded interconnect by CMP.
[Fig. 2] Fig. 2 is a schematic cross-sectional view of a semiconductor integrated circuit device for illustrating the definitions of dishing and erosion.

### DESCRIPTION OF REFERENCE NUMERALS AND SIGNS

1: Si substrate
2: Insulating layer
3: Barrier layer
4: Metal interconnect layer
5: Cap layer
6: Embedded interconnect
7: Dishing portion
8: Erosion portion
9: Polished portion in global part

### BEST MODE FOR CARRYING OUT THE INVENTION

Modes for carrying out the invention will be described below by using drawings, tables, formulae, examples and the like. Incidentally, these drawings, tables, formulae, examples and the like are merely for illustrating the invention, and are not intended to limit the scope of the invention. Other embodiments may also belong to the category of the invention, as long as they are in accordance with the purport of the invention.

The polishing composition of the invention is a polishing composition for CMP for polishing a to-be-polished surface in the production of a semiconductor integrated circuit device, and it is a composition containing an oxidizing agent, an abrasive grain, an alicyclic resin acid, a basic compound and water, and having a pH ranging from 8 to 12.

### <Abrasive Grain>

The abrasive grain is preferably an abrasive grain comprising a metal oxide, and specifically, it is preferably particles comprising at least one member selected from the group consisting of silica, alumina, ceria, zirconia, titanium oxide, tin oxide, zinc oxide, germanium oxide and manganese oxide. Silica particles are more preferred in that dispersion stability is good and in that polishing at a uniform polishing rate can be attained within the wafer plane.

The silica particles may be any, as long as they are particles mainly comprising silica, and silica particles produced by various known methods can be used. For example, colloidal silica prepared from an alkoxide compound or sodium silicate, or fumed silica obtained from silicon tetrachloride by gas-phase synthesis can be used. Of these, colloidal silica is preferred in that the particle size is easily controlled and a high-purity product can be obtained.

The average particle size of the silica particles is preferably within the range of 5 to 300 nm, in terms of polishing characteristics and dispersion stability. More preferably, the average particle size is within the range of 10 to 100 nm. The polishing composition of the invention may contain an abrasive grain other than the silica particles. However, a main component (50% to 100% in terms of the mass ratio based on the whole abrasive grain) of the abrasive grain is preferably the above-mentioned silica particles.

As the abrasive grain other than the silica particles, specifically, colloidal alumina particles, cerium oxide particles prepared by a liquid-phase method or a gas-phase method, zirconium oxide particles, titanium oxide particles, tin oxide particles, zinc oxide particles, manganese oxide particles or the like can be used. The average particle size of these particles is preferably within the range of 5 to 300 nm, and more preferably within the range of 10 to 100 nm, similarly to the silica particles.

It is preferred that the concentration of the whole abrasive grain is appropriately set within the range of 0.1 to 15% by mass based on the total amount of the polishing composition, taking the polishing rate, uniformity of the polishing rate in the wafer plane, dispersion stability and the like into consideration. The concentration is more preferably from 1 to 10% by mass, and particularly preferably within the range of 4 to 8% by mass, based on based on the total amount of the polishing composition. The concentration of each component in the polishing composition as hereinafter referred to means percentage by mass based on the total amount of the polishing composition, unless otherwise specified.

### <Oxidizing Agent>

The oxidizing agent forms an oxide film on a surface of the barrier layer, and it is considered that polishing of the barrier layer is accelerated owing to that this film is removed from the to-be-polished surface by mechanical force at the time of polishing.

As the oxidizing agent, at least one member selected from hydrogen peroxide, iodates, periodates, hypochlorites, perchlorates, persulfates, percarbonates, perborates and superphosphates can be used, and as the above-mentioned salt, salts such as ammonium salts or potassium salts are preferably used. That is, as the oxidizing agent, hydrogen peroxide, ammonium persulfate, potassium persulfate and the like are preferred, and hydrogen peroxide containing no alkali metal component and generating no harmful by-product is preferred.

From the standpoint of obtaining a sufficient effect of accelerating polishing, it is preferred that the concentration of the oxidizing agent is appropriately set within the range of 0.05 to 10% by mass based on the total amount of the polishing composition taking the polishing rate and the like into consideration. The concentration is more preferably from 0.1 to 5% by mass, and particularly preferably within the range of 0.1 to 2% by mass.

### <Alicyclic Resin Acid>

The resin acids are organic acids (carboxylic acids) present as free or ester form in natural resins, and the alicyclic resin acid means a compound having an alicyclic structure, among the resin acids (see the section of "resin acids", "Kagaku Daijiten 4 (Encyclopedia Chimica 4)" published by Kyoritsu Shuppan Co., Ltd.).
The alicyclic resin acids in the invention include natural resins containing alicyclic resin acids, purified resin acids mainly comprising alicyclic resin acids purified from natural resins (concurrently, isomerization or the like may occur in some cases), alicyclic resin acids as single compounds extracted from natural resins and a mixture of two or more kinds thereof, and the like.

The above-mentioned purified resin acids include rosin obtained from pine resin or the like, tall oil, tall oil rosin and the like. In particular, purified resin acids mainly comprising an alicyclic resin acid which is called rosin, such as abietic acid or an isomer thereof, pimaric acid or an isomer thereof or a hydrogenated abietic acid, are preferred. As the alicyclic resin acid of the invention, commercially available rosin can be used. Further, although rosin is such that the compounds contained therein and the compositional proportions thereof vary depending on the kind of natural resin from which the rosin is derived, any kind of rosin can be used as long as it contains an alicyclic resin acid as a main component. The alicyclic resin acid preferably comprises at least one member selected from the group consisting of abietic acid, isomers thereof, pimaric acid, isomers thereof, and derivatives of these compounds, for the following reason.
The reason why the rosin, particularly abietic acid, is preferred is that it is adsorbed by a Cu surface to be able to prevent corrosion. Although the polishing composition according to the invention is mainly used in the second polishing step, a barrier slurry used in the second polishing step is mainly used for treating a wafer which has been polished with a Cu slurry as the first polishing step. Since the size of dishing in the Cu interconnect portion may vary depending on the state of Cu polishing, the Cu polishing rate corresponding to the size is required in the second polishing step. For example, when the size of dishing is large, the amount of Cu required to be polished in the second polishing step becomes small relative to the peripheral insulating film. Accordingly, the necessary Cu polishing rate relatively becomes low. Further, compared to a triazole such as BTA which also has an anti-corrosion function, the materials adsorbed by Cu are easily removed by washing, so that adverse effects on subsequent steps caused by the residual anti-corrosion agent are little. Accordingly, in the polishing composition according to the invention, the concentration of BTA in the polishing composition is preferably 5% by mass or less.

Some commercially available rosin contains aliphatic resin acids in small amounts. These aliphatic resin acids are mainly composed of unsaturated higher fatty acids such as oleic acid and linoleic acid, and the content thereof is usually about 10% by mass based on the whole resin. In the polishing composition of the invention, these aliphatic resin acids are preferred compounds as an aliphatic carboxylic acid described below. Accordingly, as the alicyclic resin acid used in the production of the polishing composition of the invention, either an alicyclic resin acid not containing such an aliphatic carboxylic acid, or an alicyclic resin acid containing such an aliphatic carboxylic acid may be used. Further, the alicyclic resin acid not containing such an aliphatic carboxylic acid may be used in combination with a separate use of the aliphatic carboxylic acid, and the alicyclic resin acid containing such an aliphatic carboxylic acid may be used in combination with a sparate use of the aliphatic carboxylic acid.

The alicyclic resin acids as single compounds include abietic acid; neoabietic acid , parastrinic acid and levopimaric acid, which are isomers of abietic acid; dihydroabietic acid and tetrahydroabietic acid which are hydrides of abietic acid; dehydroabietic acid and secodehydroabietic acid which are dehydrogenation products of abietic acid; and the like. Besides, there are pimaric acid, isopimaric acid, sandaracopimaric acid, communic acid or dihydroagathic acid and the like. Specifically, the total content (mass) of abietic acid, isomers thereof and derivatives thereof is preferably 40% or more in the alicyclic resin acid (mass).

In the polishing composition of the invention, two or more kinds of the above-mentioned alicyclic resin acids may be contained. Originally, the purified resin acid such as rosin is often a mixture of two or more kinds of alicyclic resin acids (single compounds). In the polishing composition of the invention, two or more kinds of alicyclic resin acids may be contained, and rosin and one or more kinds of alicyclic resin acids as single compounds may be contained.
Further, the alicyclic resin acid in the present invention may be a compound which is the above-mentioned purified resin acid or the derivative of the alicyclic resin acid as the single compound and has at least one carboxylic group, or a mixture containing such a compound. The derivatives include isomerized products, hydrides, dehydrogenation products, multimerized products and modified products obtained by Diels-Alder addition of unsaturated compounds (for example, unsaturated carboxylic acids such as maleic anhydride, fumaric acid and acrylic acid (or an anhydride thereof)) to unsaturated groups of the alicyclic resin acids, and the like, which are other than the alicyclic resin acids extracted from the natural resins. It preferably comprises at least one kind selected from the group consisting of maleic anhydride addition products (maleic acid modified products), fumaric acid addition products (fumaric acid modified products), acrylic acid addition products (acrylic acid modified products) and dehydrogenation products. The above-mentioned dehydrogenation product also includes a compound in which an alicyclic ring is partly converted to an aromatic ring by dehydrogenation.
Specific examples of the alicyclic resin acids include (1) Pine Crystal KR614 (trade name) manufactured by Arakawa Chemical Industries, Ltd. (rosin dehydrogenated using gum rosin as a raw material, having a dehydrogenation rate of 80% and containing 75 to 85% by mass of dehydroabietic acid as a main component), (2) Rosin Soap 30K (trade name) manufactured by Arakawa Chemical Industries, Ltd. (a potassium salt of rosin prepared from gum rosin, having a composition containing as main components 39 to 65% by mass of abietic acid, 12 to 26% by mass of parastrinic acid, 10 to 23 % by mass of neoabietic acid and 6 to 9% by mass of pimaric acid, wherein the total content of abietic acid, parastrinic acid and neoabietic acid is from 85 to 90% by mass), (3) Sizepine E (trade name) manufactured by Arakawa Chemical Industries, Ltd. (a product obtained by partially modifying the above-mentioned 30K rosin with maleic acid), (4) Vandis T-25K (trade name) manufactured by Harima Chemicals Inc. (a potassium salt of a rosin modified product containing, in term of alicyclic resin acid, 50.5% by mass of dehydroabietic acid, 24.9% by mass of dihydroabietic acid, 4.1 % by mass of isopimaric acid, 5.2% by mass of an isomer of isopimaric acid, 2.8% by mass of secodehydroabietic acid and 10.4% of the others), (5) Vandis G-25K (trade name) manufactured by Harima Chemicals Inc. (trade name of a potassium salt of rosin obtained by a disproportionation reaction using gum rosin as a raw material, its typical composition containing, in term of alicyclic resin acid, 62.7% by mass of dehydroabietic acid, 22.6% by mass of dihydroabietic acid, 1.7% by mass of isopimaric acid, 8.9% by mass of an isomer of isopimaric acid and 4.1% of the othersin a typical composition), and the like.

The concentration of the alicyclic resin acid is preferably 0.001% by mass or more based on the total amount of the polishing composition in order to stabilize polishing of the copper layer. Taking the polishing rate ratio of the polishing rate of the copper layer or the insulating layer relative to the polishing rate of the barrier layer into consideration, it is preferred to appropriately set the concentration within the range of 5% by mass or less. The concentration is more preferably in the range of 0.005 to 1% by mass, and in the range of 0.005 to 0.1 % by mass.

### <Long-Chain Aliphatic Carboxylic Acid>

The polishing composition of the invention may further contain a long-chain aliphatic carboxylic acid having a long-chain hydrocarbon group having 10 to 22 carbon atoms and one or more carboxy groups. It is preferred that this long-chain aliphatic carboxylic acid contains no functional group other than the carboxy group(s). This long-chain aliphatic carboxylic acid is not an essential component. However, when the long-chain aliphatic carboxylic acid is incorporated in the polishing composition of the invention, dissolution of the alicyclic resin acid can be accelerated at the time of preparing the polishing composition, and the ratio of the polishing rate of the barrier layer and the polishing rate of the other layers such as the copper layer or the insulating layer can be adjusted. The content of the long-chain aliphatic carboxylic acid is preferably 0.001 % by mass based on the total amount of the polishing composition in order to sufficiently obtain the above-mentioned effects. In order to enhance the selectivity of polishing between the insulating layer and the cap layer, it is preferred that the long-chain aliphatic carboxylic acid is incorporated in an amount of 0.003% by mass or more. The content of the long-chain aliphatic carboxylic acid is preferably 0.5% by mass or less. When it exceeds 0.5% by mass, there is a concern that the polishing rate of the copper layer may become insufficient. Further, it is more preferably 0.1 % by mass or less.

The total carbon number (including the carbon atom of the carboxy group) of the long-chain aliphatic carboxylic acid which can be used in the polishing composition of the invention is preferably from 13 to 23, for the reasons that the solubility in a polishing agent and the Cu corrosion-prevention function are balanced and that the Cu polishing rate can be controlled to a desired value. The long-chain hydrocarbon group may have one or more unsaturated bonds, and particularly, it is preferably an unsaturated hydrocarbon group containing 1 to 3 unsaturated double bonds (i.e., an alkenyl group), for the reasons that the solubility in a polishing agent and the Cu corrosion-prevention function are balanced and that the Cu polishing rate can be controlled to a desired value.

When the long-chain aliphatic carboxylic acid contains only one carboy group, the carboxy group is preferably bonded to the carbon atom at one end of the linear hydrocarbon or a carbon atom in the vicinity thereof. When the long-chain aliphatic carboxylic acid is a long-chain aliphatic carboxylic acid containing 2 or 3 carboxy groups, it is preferred that those carboxy groups are each bonded to the same or different carbon atoms at one end of the linear hydrocarbon or in the vicinity thereof, or carbon atoms at both ends or in the vicinity thereof. In particular, a long-chain aliphatic polycarboxylic acid in which two or three carboxy groups are bonded to one or two carbon atoms in one end is preferred. In the case of the aliphatic carboxylic acid containing a plurality of carboxy groups, the long-chain hydrocarbon group means the moiety excluding the carbon atoms to which the carboxy groups are bonded.

As the long-chain aliphatic carboxylic acids, a saturated aliphatic monocarboxylic acid containing no unsaturated group in a long-chain hydrocarbon group moiety and having a total carbon number of 12 to 17, and an unsaturated aliphatic monocarboxylic acid containing one or more unsaturated groups in a long-chain hydrocarbon group moiety and having a total carbon number of 13 to 23 are can be preferably used. Such aliphatic acids include, for example, unsaturated aliphatic monocarboxylic acids such as myristoleic acid, palmitoleic acid, oleic acid, linoleic acid, linolenic acid, arachidonic acid, eicosapentaenoic acid, erucic acid, brassidic acid and docosahexaenoic acid, and saturated aliphatic monocarboxylic acids such as lauric acid, myristic acid and palmitic acid.

Further, as the long-chain aliphatic carboxylic acid, a long-chain aliphatic polycarboxylic acid can be also preferably used. As such a long-chain aliphatic polycarboxylic acid, an alkenyl succinic acid is preferably used which is a compound in which the above-mentioned long-chain alkenyl group is bonded to the carbon atom at the 2-position of succinic acid. The alkenyl succinic acid is a compound in which the above-mentioned long-chain alkenyl group is bonded to the carbon atom at the 2-position of succinic acid, and it includes decenylsuccinic acid, dodecenylsuccinic acid, tetradecenylsuccinic acid, hexadecenylsuccinic acid, octadecenylsuccinic acid and the like. An alkenyl succinic acid having a total carbon number of 14 to 22 is preferred.
Incorporation of the long-chain aliphatic carboxylic acid in addition to the alicyclic resin acid can attain both of the adjustment of the polishing rates and the protection of the Cu layer, and hence it is preferred.

### <Water, Basic Compound, Inorganic Acid and pH>

Water is a solvent for dispersing the abrasive grain and for dissolving the agents, and pure water or deionized water is preferred. Since water has a function of controlling fluidity of the polishing composition, the content thereof can be appropriately set in accordance with the target polishing characteristics such as the polishing rates and planarization characteristics. The amount thereof is usually 78% by mass or more, and preferably 85% by mass or more, based on the total amount of the polishing composition.

This polishing composition contains a basic compound. As the basic compound, ammonia, potassium hydroxide or a quaternary ammonium hydroxide such as tetramethylammonium hydroxide or tetraethylammonium hydroxide (hereinafter referred to TEAH) can be used, and preferably, ammonia is used.

The concentration of the basic compound is preferably from 0.1 to 20% by mass based on the total amount of the polishing composition. Adjustment of the amount of the basic compound added changes the polishing rate of each layer, particularly the polishing rate of the barrier layer or the insulating layer, thereby making it possible to adjust the polishing rate ratio of the barrier layer or the insulating layer relative to the interconnect metal layer. Further, it is possible to improve the dispersion stability of the polishing composition. The concentration of the basic compound is more preferably in the range of 1 to 10% by mass, still more preferably from 0.1 to 5% by mass, and particularly preferably in the range of 0.1 to 2% by mass.

The polishing composition may contain an inorganic acid together with the basic compound. As the inorganic acid, at least one member selected from the group consisting of nitric acid and sulfuric acid is preferred. Of these, nitric acid which is an oxo acid having oxidizability and contains no halogen is preferred. The content of the inorganic acid is preferably from 0.1 to 10% by mass based on the total amount of the polishing composition. Adjustment of the amount of the acid added changes the polishing rate of the barrier layer or the insulating layer, thereby making it possible to adjust the polishing rate ratio of the barrier layer or the insulating layer relative to the interconnect metal layer. Further, it is also possible to improve the dispersion stability of the polishing composition. In the case of less than 0.1 % by mass, there is a concern of failing to obtain the sufficient polishing rate relative to the barrier layer. In the case of exceeding 10% by mass, there is a concern of deteriorated dispersion stability. The concentration of the acid is more preferably from 0.1 to 5% by mass, and particularly preferably from 0.1 to 2% by mass.

Furthermore, the polishing composition of the invention may further contain an organic acid other than the above-mentioned long-chain aliphatic carboxylic acid. When the organic acid is incorporated, the polishing rate of the copper film can be adjusted. This organic acid is a monocarboxylic acid or polycarboxylic acid not having the above-mentioned long-chain hydrocarbon group, and may have a functional group such as a hydroxyl group or an amino group, in addition to the carboxyl group(s). In particular, a polycarboxylic acid, a carboxylic acid having a hydroxyl group and a carboxylic acid having an amino group are preferred. This organic acid may have a linear hydrocarbon group, and the carbon number of the linear hydrocarbon group is less than 10, and preferably 6 or less. Although it may be an aromatic carboxylic acid, it is preferably an aliphatic carboxylic acid. The total carbon number thereof is preferably 12 or less, and particularly preferably 8 or less. The most preferred organic acid is an aliphatic polycarboxylic acid with a total carbon number of 8 or less, which has 2 or 3 carboxy groups and may have a hydroxyl group.

Specific examples of the organic acids include oxalic acid, malonic acid, succinic acid, maleic acid, glutaric acid, adipic acid, lactic acid, malic acid, citric acid, isocitric acid, tartaric acid, glycolic acid, gluconic acid, salicylic acid, alanine, glycine, proline, phenylalanine, fumaric acid, maleic acid, oxalacetic acid, citraconic acid, itaconic acid, phthalic acid and the like. Of these, it is preferred to use citric acid, succinic acid, tartaric acid, malic acid and oxalic acid, and more preferably, citric acid is used. When the organic acid is incorporated in an amount of 0.05% by mass or more, the polishing rate of the copper film is adjusted, and the ratio of the polishing rate of the insulating layer, PR_{Ins}, and the polishing rate of the cap layer, PR_{Cap}, which is described below, can be decreased. This is therefore preferred. The content of the organic acid is preferably the same equivalent as or less than that of the inorganic acid, in terms of polishing stability of the copper film. From the viewpoint of decreasing the ratio of the insulating layer polishing rate PR_{Ins} and the cap layer polishing rate PR_{Cap}, it is preferred that the organic acid is incorporated together with the long-chain aliphatic carboxylic acid.

Taking various factors such as polishing characteristics, washability of the to-be-polished surface after polishing and dispersion stability of the polishing composition into consideration, the pH of the polishing composition is from 8 to 12. Specifically, in the polishing composition of the invention, it is preferred that the basic compound is adjusted in concentration within the above-mentioned concentration range and incorporated so as to attain a desired pH value in the range of 8 to 12, after the contents of the other components such as the organic acid are determined in the case where the alicyclic resin acid, the inorganic acid and the organic acid are contained. In the polishing composition of the invention, it is also preferred that the alicyclic resin acid, the inorganic acid, the aliphatic carboxylic acid and the organic acid are incorporated after having been previously converted to salts with the basic compound.

According to the polishing composition, the polishing rate ratio of the barrier layer, the interconnect metal layer, the insulating layer and the cap layer particularly suitable for the second polishing step can be obtained by using the above-mentioned respective components in combination and adjusting the pH within such a range.
Then, a polishing composition extremely excellent in dispersion stability in which coagulation is hard to occur at the time of storage can be obtained. Further, a polishing composition which makes it easy to wash the to-be-polished surface after polishing can be obtained. In order that more excellent polishing characteristics and dispersibility are compatible with each other, the pH is more preferably 9 or more. Further, taking corrosion of the to-be-polished surface into consideration, it is preferably 10 or less.

### <Other Components>

In the polishing composition according to the invention, a pH buffering agent, a surfactant, a chelator, a reducing agent, a viscosity-imparting agent or a viscosity-adjusting agent, a coagulation preventing agent or a dispersing agent, an anti-corrosion agent or the like may be appropriately contained as needed, as long as the effects of the invention are obtained. However, when these agents have a function of an oxidizing agent, an acid, a level difference-eliminating agent or a viscosity-adjusting agent, they are treated as the oxidizing agent, the acid, the level difference-eliminating agent or the viscosity-adjusting agent.

Other components preferably contained include pullulan, water-soluble cellulose, ethylene glycol and the like. By further incorporating pullulan, the polishing rate of the silicon dioxide layer is improved, so that the polishing rate ratios of the barrier layer and the copper layer relative to the cap layer can be adjusted. In order to improve the fluidity or dispersion stability of the polishing composition or the polishing rate, an organic solvent such as ethylene glycol can be also contained.

### <Material to Be Polished>

The polishing composition according to the invention is suitable for obtaining a flat surface of an insulating layer having an embedded metal interconnect layer in the production of a semiconductor integrated circuit device. In particular, it is suitable for polishing the to-be-polished surface formed by laminating a barrier layer and a metal interconnect layer on an insulating layer on which trenches for forming embedded interconnects are formed. That is, the polishing composition according to the invention has both functions of high-rate polishing of the barrier layer and planarization of the insulating layer having the embedded metal interconnect layer.

In particular, when the barrier layer is a layer comprising one or more member selected from the group consisting of tantalum, tantalum alloys and tantalum compounds, the effect of high planarization is obtained. However, it can be also applied to a film composed another metal or the like. Also when a film comprising a metal other than tantalum or a metal compound thereof, for example, a film comprising Ti, TiN, TiSiN, WN or the like, is used as the barrier layer, a sufficient effect is obtained.

As a material constituting the insulating layer which is one of the objects to be polished by the polishing composition of the invention, any of known materials may be used. For example, a silicon dioxide film can be exemplified. As the silicon dioxide film, there is generally used one having a crosslinked structure of Si and O, in which the ratio of the number of atoms of Si and O is 1:2, but other ones may be also used. As such a silicon dioxide film, one deposited by plasma-CVD using tetraethoxysilane (TEOS) or silane gas (SiH₄) is generally known.

Further, the polishing composition according to the invention can be also suitably used to a film composed of a low-dielectric material having a specific dielectric coefficient of 3 or less, which has recently come to be used as an insulating layer for the purpose of suppressing signal delay, for example, a film composed of fluorine-added silicon oxide (SiOF), an organic SOG film (a film containing an organic component obtained by spin on glass), a low-dielectric material film such as a porous silica film, or a film of an organic silicon material (generally transcribed as SiOC) mainly constituted by Si-O bonds and containing Si-CH₃ bonds.

The organic silicon materials which are low-dielectric materials include trade name: Black Diamond (specific dielectric coefficient: 2.7, technology of Applied Materials, Inc.), trade name: Coral (specific dielectric coefficient: 2.7, technology of Novellus Systems, Inc.) and Aurora 2.7 (specific dielectric coefficient: 2.7, technology of ASM Japan K.K.). In particular, a compound having Si-CH₃ bonds is preferably used.

The polishing composition according to the invention can be also suitably used in the case where a cap layer is formed on the insulating layer. That is, in a multi-layer structure in which a cap layer, a barrier layer and a metal interconnect layer are sequentially laminated on a low-dielectric insulating layer, after the cap layer is completely removed, the polishing composition is suitable for scraping the insulating layer to perform planarization.

When a low-dielectric material is used as the insulating layer, the cap layer is a layer provided for the purpose of increasing adhesion between the insulating layer and the barrier layer, using as a mask material at the time when trenches for embedding the metal interconnect layer are formed by etching on the low-dielectric insulating layer which is chemically and mechanically fragile, or preventing deterioration of the low-dielectric material.

As the cap layer, a film having silicon and oxygen as constituent elements is generally used. As such a film, a silicon dioxide film can be exemplified. As the silicon dioxide film, there is generally used one having a crosslinked structure of Si and O, in which the ratio of the number of atoms of Si and O is 1:2, but other ones may be also used. As such a silicon dioxide film, one deposited by plasma-CVD using tetraethoxysilane (TEOS) or silane gas (SiH₄) is generally known.

The polishing composition according to the invention can be particularly suitably used, when such a silicon dioxide film formed by depositing tetraethoxysilane (TEOS) by CVD is used as the cap layer according to the invention, and trade name: Black Diamond (specific dielectric coefficient: 2.7, technology of Applied Materials, Inc.) which is a compound having Si-CH₃ bonds is used as the organic silicon material of the low-dielectric material.

When the metal interconnect layer which is an object of the polishing composition according to the invention is one or more kinds selected from copper, copper alloys and copper compounds, a high effect is obtained. However, the polishing composition is also applicable to metals other than copper, for example, to films of metals such as Al, W, Ag, Pt and Au.

It is preferred that the polishing composition of the invention has the relationships that its polishing rate of the barrier layer, PR_{BR}, is equal to or higher than each of its polishing rate of the copper layer, PR_{Cu}, its polishing rate of the cap layer, PR_{Cap}, and its polishing rate of the insulating layer, PR_{Ins}, and that the ratio of the insulating layer polishing rate PR_{Ins}, and the cap layer polishing rate PR_{Cap}, PR_{Ins}/PR_{Cap,} is 0.7 or less.. That is, it is preferred that the polishing composition of the invention has "selective polishing characteristics".
Incidentally, the ratio PR_{Ins}/PR_{Cap} of the insulating layer polishing rate PR_{Ins} and the cap layer polishing rate PR_{Cap} can be adjusted by adjusting the pH of the polishing composition. Specifically, it is also possible to adjust PR_{Ins}/PR_{Cap} to 1 or more by increasing the pH.
Further, the ratios of the polishing rates of the copper layer, the cap layer and the insulating layer relative to the polishing rate of the barrier layer can be adjusted by adjusting the pH of the polishing composition or the contents of the respective components. The polishing rate of each of the copper layer, the barrier layer, the insulating layer and the cap layer can be determined by performing a polishing test to a blanket wafer of each layer.

Since the polishing composition according to the invention has such a constitution, it is suitably used, in regard to a to-be-polished surface formed by forming a concave portion such as an interconnect trench pattern or a via on an insulating layer on a substrate, then, forming a barrier layer, and thereafter, forming a film by a sputtering method or a plating method for embedding a metal, for example, copper, in the trench portion, in a method comprising removing the metal and the barrier layer by CMP until the surface of the insulating layer except for the trench portion is exposed, thereby forming the embedded metal interconnect layer.

Further, two-step polishing is performed in some cases, which performs, in the step of forming the embedded interconnect layer in the production of the semiconductor integrated circuit device, a first polishing step of polishing the above-mentioned to-be-polished surface until the barrier layer is exposed, and thereafter, a second polishing step of removing the barrier layer and the cap layer and polishing a part of the insulating layer to form a flat surface where the insulating layer and the surface of the metal interconnect layer embedded in the trench portion have the same surface level. Since the polishing composition according to the invention particularly has both functions of high-rate polishing of the barrier layer and planarization of the insulating layer having the embedded metal interconnect layer, it can be particularly suitably used as the polishing composition for the second polishing step.

In the CMP technique, such characteristics are considered to be obtained by fusion of chemical polishing attributable to the agent formulation of the polishing composition and mechanical polishing brought about by the abrasive grain, and are the effects which could not have been realized by conventional polishing compositions. Further, the to-be-polished surface polished by using the polishing composition has extremely little amount of components of the polishing composition that are adsorbed thereby and remain thereon, so that adverse effects on subsequent steps caused by the residual materials can be inhibited.

In the polishing composition of the invention, the polishing rate ratio of each of the copper layer, the cap layer and the insulating layer relative to the barrier layer can be adjusted. Accordingly, the polishing composition of the invention can be preferably used even when, in the second polishing step, the barrier layer is not completely removed and partially polished, without being limited to the case of completely removing the above-mentioned cap layer. Further, it can be also preferably used to a to-be-polished surface having no cap layer on the insulating layer, similarly to the to-be-polished surface having the cap layer. As the to-be-polished surface having no cap layer on the insulating layer, there is exemplified a to-be-polished surface in which a trench portion is formed on the above-mentioned insulating layer comprising silicon dioxide, and a barrier layer and a copper layer are formed in this order.

The polishing composition of the invention can be applied to a polishing method of supplying the polishing composition to a polishing pad, bringing the polishing pad into contact with the to-be-polished surface, and relatively moving the to-be-polished surface and the polishing pad to perform polishing. Polishing may be performed while conditioning the surface of the polishing pad by bringing a pad conditioner into contact with the surface of the polishing pad, as needed.

It is not necessarily required that the polishing composition of the invention is supplied to the site of polishing in the state of all the constituent polishing materials having been previously mixed, and what is required is merely that all polishing materials constituting the polishing composition according to the invention are mixed at the time when polishing is performed. Further, since no low-solubility component is contained, a stock solution having a concentrated composition may be diluted to a desired concentration to use at the time when polishing is performed.

### EXAMPLES

The invention will be described below in more detail with reference to Examples 1 to 8 of Invention Examples and Example 9 of Comparative Example.

### (1)Preparation of Polishing Composition

(a) Respective polishing compositions of Examples 1 to 9 were prepared as follows. A basic compound, an alicyclic resin acid and an acid were added to water, followed by stirring for 10 minutes. Pure water was used as the water. Then, an aqueous dispersion of an abrasive grain was gradually added, and an oxidizing agent was added, followed by further stirring for 30 minutes to obtain a polishing composition of each Example. The concentration of each component in the polishing composition of each Example is as shown in concentration (% by mass) based on the total mass of the polishing composition in Table 1, and water accounts for the remainder of the total amount of the respective components.

KR614 in the column of the alicyclic resin acid represents dehydrogenated rosin (trade name: Pine Crystal KR614) manufactured by Arakawa Chemical Industries, Ltd. using gum rosin as a raw material, and 30K represents a rosin potassium salt-containing aqueous solution (trade name: Rosin Soap 30K) manufactured by Arakawa Chemical Industries, Ltd. Pine Crystal KR614 has a dehydrogenation rate of 80% and contains 75 to 85% by mass of dehydroabietic acid as a main component. Rosin Soap 30K contains fatty acid potassium salts mainly comprising potassium salts of linoleic acid and oleic acid in an amount of about 13% by mass based on the total amount of combined solid matter of rosin potassium salt and the fatty acid potassium salts.

As the abrasive grain, silica particles having an average particle size of 40 nm were used, and as the alkenyl succinic acid, Latemul ASK (trade name, the carbon number of the alkenyl group is said to be about 16) manufactured by Kao Corporation was used.

### (2) Measurement of Average Particle Size of Polishing Composition

For the polishing composition of Example 1, the average particle size was measured by using Microtruck UPA manufactured by Nikkiso Co., Ltd. The average particle size of the abrasive grain in the polishing composition was 40 nm both just after preparation and after storage at room temperature for 14 days, and the dispersion stability was good. Incidentally, it was also good for Examples 2 to 8 as well.

### (3) Polishing Conditions

Polishing was performed using the following apparatus and conditions.

Polishing machine: full-automatic CMP apparatus MIRRA (manufactured by Applied Materials, Inc.)
Polishing pressure: 14 kPa
Rotation frequency: platen, 103 rotations/min (rpm); head (substrate holding portion), 97 rpm
Polishing composition supply rate: 200 ml/min
Polishing pad: IC1400-k groove (manufactured by Rodel Co.)

### (4) Material to Be Polished

Blanket wafers of the following (a) to (d) were used.

(a) Wafer for Evaluating Polishing Rate of Metal Interconnect Layer (Copper Layer)
An 8-inch wafer in which a 1,500-nm thick copper layer was formed on a substrate by plating was used.

(b) Wafer for Evaluating Polishing Rate of Barrier Layer (Tantalum Layer)
An 8-inch wafer in which a 200-nm thick tantalum layer was formed on a substrate by sputtering was used.

(c) Wafer for Evaluating Polishing Rate of Cap Layer (Silicon Dioxide Layer)
An 8-inch wafer in which an 800-nm thick silicon oxide layer was formed on a substrate by plasma CVD was used.

(d) Wafer for Evaluating Polishing Rate of Insulating Layer (SiOC Layer)
An 8-inch wafer in which an 800-nm thick SiOC layer was formed on a substrate by plasma CVD was used.

(e) Wafer with Patterns
An 8-inch wafer (854 patterns) manufactured by Sematech Inc. was used.

### (5) Method for Evaluating Polishing Rate

The polishing rate was calculated from the film thicknesses before and after polishing. For measurement of the film thickness, a sheet resistance measuring apparatus, RS75 (manufactured by KLA-Tencor Inc.) in which calculation is made from surface resistance by a four probe method was used for copper and tantalum, and an optical interference type full-automatic film thickness measuring apparatus, UV1280SE (manufactured by KLA-Tencor Inc.) was used for the low-dielectric insulating layer and the cap layer.

### (6) Evaluation of Blanket Wafer Polishing Characteristics

Each of the above-mentioned blanket wafers was polished using the polishing composition of each Example, and the polishing rate of each of the copper layer, the barrier layer, the cap layer and the insulating layer was determined from a change in layer thickness between before and after polishing.

Table 2 shows the polishing rates (the unit being nm/min) of the respective layers of the copper layer (Cu), the barrier layer (Ta), the cap layer (SiO₂) and the insulating layer (SiOC) obtained by using the respective blanket wafers. From the results of Examples 1 to 8, it can be seen that the polishing compositions of the present invention can polish the barrier layer at a rate as high as 50 nm/min or more, that the polishing rate of the barrier layer is equal to or higher than each of the polishing rates of the copper layer, the insulating layer and the cap layer, and that the ratio of the insulating layer polishing rate PR_{Ins} and the cap layer polishing rate PR_{Cap} , PR_{Ins}/P_{Cap}, is 0.7 or less.

Further, to-be-polished surfaces after the copper layer blanket wafers were polished with the polishing element compositions of Examples 1 to 8 showed hydrophilicity.

### (7) Evaluation of Pattern Polishing Characteristics

With reference to the polishing compositions of Example 2 and Example 8, the surface difference in level between the insulating film surface and the copper interconnect surface, i.e., the dishing amount, was measured with a profiler, HRP-100 (manufactured by KLA-Tencor Inc.) for patterns having an interconnect width of 100 µm and an interconnect distance of 100 µm, which was formed after polishing, and the degree of the copper interconnect pattern surface scraped from the insulating film surface by polishing was evaluated as follows.

In the pattern wafer used in this evaluation, the initial film thickness of the copper layer 4 was 800 nm, and the initial difference in level was 400 nm. First, the excess copper layer was removed, and polishing was performed until the tantalum layer 3 as the barrier layer was exposed, thereby performing the first polishing.

When the first polishing was performed to the pattern wafer having a cross-sectional shape shown in Fig. 1(a), which had the barrier layer 3 composed of Ta, the copper layer 4 to be formed into the interconnect metal layer 6 composed of Cu, the cap layer 5 composed of SiO₂ with the trench portion formed and the insulating layer 2 composed of SiOC, there was obtained a cross-sectional shape as shown in Fig. 1(b), in which the barrier layer 3 was exposed. The dishing amount of the pattern wafer used in this evaluation after the first polishing indicated by the arrow 7 was 30 nm at an isolated interconnect site having an interconnect width of 100 µm.

Then, using the polishing compositions of Example 2 and Example 8, respectively, the second polishing was performed. First, the barrier layer 3 having a thickness of 25 nm was removed (Fig. 1(c)). Next, about 40 nm of the cap layer composed of SiO₂ having a thickness of 70 nm was scraped to finish the second polishing step. In each cross-section of the wafer after the second polishing step was performed using each polishing composition, there was obtained a flat surface in which the interconnect metal layer 6 and the cap layer 5 on the insulating layer 2 were made mutually flat in a flat plane, and the dishing amount (not shown) at the above-mentioned isolated interconnect site was suppressed as small as 10 nm.

In the above-mentioned Examples, the case of performing the second polishing partially leaving the cap layer 5 was described. However, even in the case of entirely removing the cap layer 5 and further scraping the insulating layer 2, or in the case of performing the second polishing to a to-be-polished surface having no cap layer 5, if the second polishing is similarly performed to the pattern wafer in which dishing is generated by the first polishing, using the polishing composition of the invention, the unnecessary barrier layer is removed and dishing or erosion generated in the first step is removed, thereby providing a flat surface in which the interconnect metal layer and the insulating layer are made mutually flat in a flat plane.

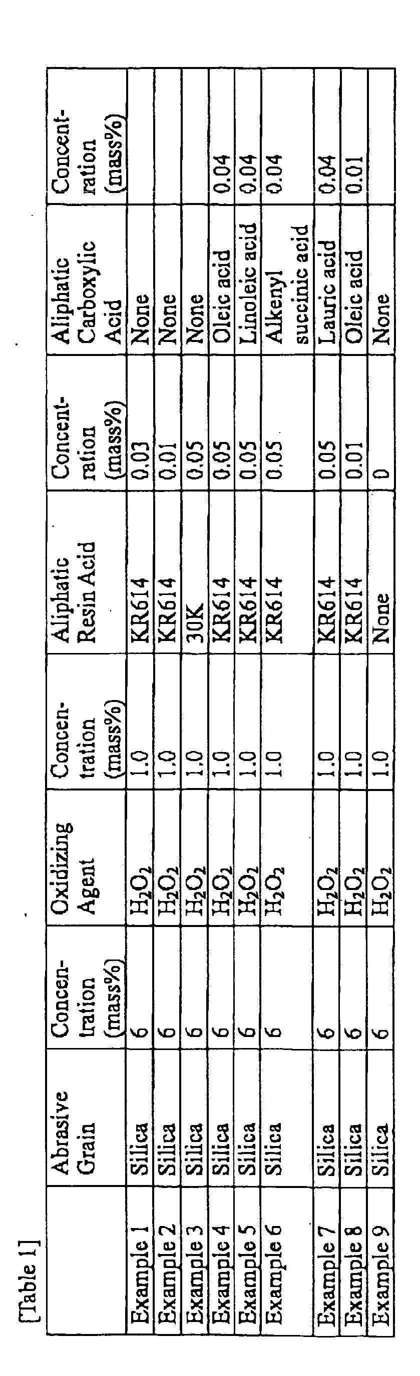

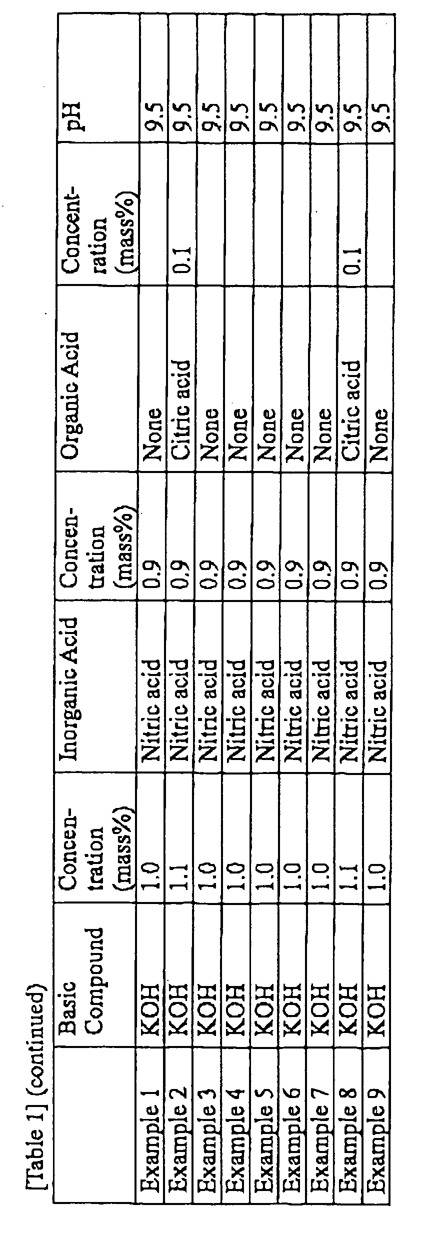

**[Table 2]**

| Example | Ta Polishing Rate (nm/min) | Cu Polishing Rate (nm/min) | SiO₂ Polishing Rate (nm/min) | SiOC Polishing Rate (nm/min) | Cu/Ta Ratio | SiO₂/Ta Ratio | SiOC/Ta Ratio | SiOC/SiO₂ Ratio |
|---|---|---|---|---|---|---|---|---|
| Example 1 | 92 | 16 | 31 | 19 | 0.17 | 0.34 | 0.21 | 0.61 |
| Example 2 | 83 | 44 | 23 | 16 | 0.53 | 0.28 | 0.19 | 0.70 |
| Example 3 | 88 | 14 | 30 | 11 | 0.16 | 0.34 | 0.13 | 0.37 |
| Example 4 | 89 | 13 | 30 | 10 | 0.15 | 0.34 | 0.11 | 0.33 |
| Example 5 | 89 | 10 | 30 | 6.0 | 0.11 | 0.34 | 0.07 | 0.20 |
| Example 5 | 93 | 10 | 30 | 7.0 | 0.11 | 0.32 | 0.08 | 0.23 |
| Example 7 | 92 | 5.0 | 30 | 10 | 0.05 | 0.33 | 0.11 | 0.33 |
| Example 8 | 80 | 24 | 30 | 10 | 0.30 | 0.38 | 0.13 | 0.33 |
| Example 9 | 97 | 16 | 34 | 47 | 0.16 | 0.35 | 0.48 | 1.38 |

While the present invention has been described in detail and with reference to specific embodiments thereof, it will be apparent to one skilled in the art that various changes and modifications can be made therein without departing from the spirit and scope thereof.
This application is based on Japanese Patent Application No. 2007-162768 filed June 20, 2007, and the contents thereof are herein incorporated by reference.

### INDUSTRIAL APPLICABILITY

When second polishing is performed using the polishing composition of the invention to a to-be-polished surface in which a barrier layer is exposed by first polishing for polishing an excess copper layer, in CMP of a production step of an embedded metal interconnect in a production step of a semiconductor integrated circuit device, dishing or erosion generated in the first polishing is removed, making it possible to finish the to-be-polished surface to a flat surface in which an interconnect metal layer and a insulating layer are made to have the same surface level. At this time, polishing can be performed while reducing scratches. Accordingly, an increase in interconnect resistance or electromigration is inhibited to realize the semiconductor integrated circuit device having high reliability. Further, since washing of the to-be-polished surface after CMP is easy, adverse effects on subsequent steps caused by that components of the polishing composition are adsorbed to remain thereon can be inhibited.

## Claims

1. A polishing composition containing an oxidizing agent, an abrasive grain, an alicyclic resin acid, a basic compound and water, and having a pH ranging from 8 to 12.

2. The polishing composition according to claim 1, containing 0.05 to 10% by mass of the oxidizing agent, 0.1 to 15% by mass of the abrasive grain, 0.001 to 5% by mass of the alicyclic fatty acid, 0.1 to 20% by mass of the basic compound and 78% by mass or more of water, each based on the total amount of the polishing composition.

3. The polishing composition according to claim 1 or 2, wherein the alicyclic resin acid is at least one member selected from the group consisting of abietic acid, isomers of abietic acid, pimaric acid, isomers of pimaric acid, rosin, and derivatives of these compounds.

4. The polishing composition according to any one of claims 1 to 3, wherein the oxidizing agent is one or more member selected from the group consisting of hydrogen peroxide, ammonium persulfate and potassium persulfate.

5. The polishing composition according to any one of claims 1 to 4, wherein the basic compound is at least one member selected from the group consisting of basic potassium compounds, ammonium and organic amines.

6. The polishing composition according to any one of claims 1 to 5, wherein the abrasive grain is particles comprising at least one member selected from the group consisting of silica, alumina, ceria, zirconia, titanium oxide, tin oxide, zinc oxide, germanium oxide and manganese oxide.

7. The polishing composition according to any one of claims 1 to 6, wherein the abrasive grain has an average particle size of 5 to 300 nm.

8. The polishing composition according to any one of claims 1 to 7, further comprising an inorganic acid, wherein the content of the inorganic acid is 0.1 to 10% by mass based on the total amount of the polishing composition.

9. The polishing composition according to any one of claims 1 to 8, further comprising a long-chain aliphatic carboxylic acid having at least a long-chain hydrocarbon group having 10 to 22 carbon atoms and one or more carboxy groups.

10. The polishing composition according to any one of claims 1 to 9, comprising at least one organic carboxylic acid selected from the group consisting of citric acid, succinic acid, tartaric acid, malic acid and oxalic acid.

11. The polishing composition according to any one of claims 1 to 10, which gives a polishing rate of a barrier layer, PR_{BR}, that is equal to or higher than each of its polishing rate of a copper layer, PR_{Cu}, its polishing rate of a cap layer, PR_{Cap}, and its polishing rate of an insulating layer, PR_{Ins}, and wherein the ratio of the insulating layer polishing rate PR_{Ins} and the cap layer polishing rate PP_{Cap}, PR_{Ins}/PR_{Cap}, is 0.7 or less.

12. The polishing composition according to any one of claims 1 to 11, comprising 0.1 to 5% by mass of hydrogen peroxide, 1 to 10% by mass of silica particles, 0.001 to 5% by mass of the alicyclic fatty acid, 0.1 to 10% by mass of the basic compound and 85% by mass or more of water, each based on the total amount of the polishing composition.

13. A method for producing a semiconductor integrated circuit device, wherein the semiconductor integrated circuit device comprises an insulating layer having a trench portion, and an embedded metal interconnect formed in the trench portion,
the method comprising a step of polishing a to-be-polished surface comprising a barrier layer and a metal interconnect layer formed in this order in the trench portion, by using the polishing composition according to any one of claims 1 to 12, to form the embedded metal interconnect.

14. The method for producing a semiconductor integrated circuit device according to claim 13, wherein the metal interconnect layer comprises copper as a main component, and the barrier layer comprises one or more member selected from the group consisting of tantalum, tantalum alloys and tantalum compounds.

15. The method for producing a semiconductor integrated circuit device according to claim 13 or 14, wherein the insulating layer comprises a low-dielectric insulating layer made of a low-dielectric material and a cap layer formed thereon, and the barrier layer and the metal interconnect layer are formed on the trench portion and the cap layer.
